# EUROPEAN PATENT SPECIFICATION

(11) **EP 3 701 587 B1**
(45) Date of publication and mention of the grant of the patent: **19.11.2025**
(21) Application number: 18797197.3
(22) Date of filing: 26.10.2018
(51) Int. Cl.: H01P 3/12, H01P 3/18, H01P 3/06, H01P 1/20

(54) **MULTI-LAYER WAVEGUIDE, ARRANGEMENT, AND METHOD FOR PRODUCTION THEREOF**
MEHRSCHICHTIGER WELLENLEITER, ANORDNUNG UND VERFAHREN ZUR HERSTELLUNG DAVON
GUIDE D'ONDES MULTICOUCHE, DISPOSITION, ET PROCÉDÉ DE PRODUCTION ASSOCIÉ

(30) Priority: 27.10.2017 SE 1751333
(43) Date of publication of application: 02.09.2020
(73) Proprietor: Gapwaves AB, 412 63 Göteborg (SE)
(72) Inventor: HE, Zhongxia Simon, 429 42 Särö (SE); VOSOOGH, Abbas, 417 60 Göteborg (SE)
(74) Representative: Lind Edlund Kenamets Intellectual Property AB
(86) International application number: PCT/SE2018/051099
(87) International publication number: WO 2019/083439

(56) References cited:
- US-A- 5 982 256
- US-A- 5 982 256
- EL-AKHDAR ABDELRAHMAN M ET AL: "A study on double via row configuration for SIW based structures", 2016 28TH INTERNATIONAL CONFERENCE ON MICROELECTRONICS (ICM), IEEE, 17 December 2016 (2016-12-17), pages 77 - 80, XP033061587, DOI: 10.1109/ICM.2016.7847912
- DONG YUN JUNG ET AL: "High- Q Circular LTCC Resonator Using Zigzagged Via Posts and a $\lambda/4$ Short Stub for Millimeter-Wave System-on-Package Applications", IEEE TRANSACTIONS ON ADVANCED PACKAGING., vol. 32, no. 1, 9 January 2009 (2009-01-09), PISCATAWAY, NJ, USA, pages 216 - 222, XP055542570, ISSN: 1521-3323, DOI: 10.1109/TADVP.2008.2007237
- WONG SAI-WAI ET AL: "U-Shape Slots Structure on Substrate Integrated Waveguide for 40-GHz Bandpass Filter Using LTCC Technology", IEEE TRANSACTIONS ON COMPONENTS, PACKAGING AND MANUFACTURING TECHNOLOGY, IEEE, USA, vol. 5, no. 1, 24 November 2014 (2014-11-24), pages 128 - 134, XP011569907, ISSN: 2156-3950, [retrieved on 20150113], DOI: 10.1109/TCPMT.2014.2367516
- FABRIZIO GATTI ET AL: "A Novel Substrate Integrated Coaxial Line (SICL) for Wide-Band Applications", MICROWAVE CONFERENCE, 2006. 36TH EUROPEAN, 10 September 2006 (2006-09-10) - 15 September 2006 (2006-09-15), Pi, pages 1614 - 1617, XP055542924, ISBN: 978-2-9600551-6-0, DOI: 10.1109/EUMC.2006.281409
- EL-AKHDAR ABDELRAHMAN M ET AL: "A study on double via row configuration for SIW based structures", 2016 28TH INTERNATIONAL CONFERENCE ON MICROELECTRONICS (ICM), IEEE, 17 December 2016 (2016-12-17), pages 77 - 80, XP033061587, DOI: 10.1109/ICM.2016.7847912
- DONG YUN JUNG ET AL: "High- Q Circular LTCC Resonator Using Zigzagged Via Posts and a $\lambda/4$ Short Stub for Millimeter-Wave System-on-Package Applications", IEEE TRANSACTIONS ON ADVANCED PACKAGING., vol. 32, no. 1, 9 January 2009 (2009-01-09), PISCATAWAY, NJ, USA, pages 216 - 222, XP055542570, ISSN: 1521-3323, DOI: 10.1109/TADVP.2008.2007237
- WONG SAI-WAI ET AL: "U-Shape Slots Structure on Substrate Integrated Waveguide for 40-GHz Bandpass Filter Using LTCC Technology", IEEE TRANSACTIONS ON COMPONENTS, PACKAGING AND MANUFACTURING TECHNOLOGY, IEEE, USA, vol. 5, no. 1, 24 November 2014 (2014-11-24), pages 128 - 134, XP011569907, ISSN: 2156-3950, [retrieved on 20150113], DOI: 10.1109/TCPMT.2014.2367516
- FABRIZIO GATTI ET AL: "A Novel Substrate Integrated Coaxial Line (SICL) for Wide-Band Applications", MICROWAVE CONFERENCE, 2006. 36TH EUROPEAN, 10 September 2006 (2006-09-10) - 15 September 2006 (2006-09-15), Pi, pages 1614 - 1617, XP055542924, ISBN: 978-2-9600551-6-0, DOI: 10.1109/EUMC.2006.281409

## Description

### Technical field

The present invention relates generally to a multi-layer waveguide (MLW) that is cost-effective to produce and possible to surface mount.

### Background art

Waveguides are well known in the art and a common component used to carry electromagnetic waves from a starting point to an endpoint. In its most general term, a waveguide could be a hollow metal pipe.

For waves propagating in open space power is lost over distance reducing both the possible transmission distance and the quality of a wave. Waveguides are therefore a structure adapted to guide waves by restricting the expansion directions of the wave in at least one dimension. The concept is to restrict the wave forcing it to propagate in a specific direction and thereby reducing the losses. In ideal conditions, this would result in the wave losing no power at all, however this is rarely or never the case. Depending on the waveguide design there is leakage and the waves couple to the edges of the waveguide channels creating energy losses. The concept of waveguides has been known for a long time and is used for transmitting for example signals, sound, or light.

In prior art, such as EL-AKHOAR ABOELRAHMAN M ET AL: "A study on double via row configuration for SIW based structures", DONG YUN JUNG ET AL: "High- Q Circular L TCC Resonator Using Zigzagged Via Posts and a M4 Short Stub for Millimeter-Wave System-an-Package Applications*",* US5,982,256A, WONG SAI-WAI ET AL: "U-Shape Slots Structure on Substrate Integrated Waveguide for 40-GHz Bandpass Filter Using L TCC Technology*",* and FABRIZIO GATTI ET AL: "A Novel Substrate Integrated Coaxial Line (SICL) for Wide-Band Applications*",* different substrate integrated waveguide (SIW) structures are described. SIW are laminated waveguides formed in dielectric substrates with via-holes that creates electric connection between metal plates of the substrate. A drawback of SIW is that optimal electric connection is required between the metal plates.

### Summary of invention

Although many different forms of waveguides are known in the art there are drawbacks with the current solutions. It has been realized during the development of the present solution that it, for example, is difficult to produce waveguides that are suitable for application areas requiring surface mounted waveguides.

In general application for electromagnetic radio waves, rectangular waveguides could be used being essentially a hollow metal structure with a rectangular cross section. Those could for example be produced with two blocks of metal that are assembled into a waveguide. Such waveguides might have a top and a bottom layer assembled together. Part of these two layers are cut out, so that when these two layers when assembled together forms a hollow space as waveguide. The two blocks need to have good connectivity to reduce leakage. However, due to the fact that there are only small portion of the layers are cut out and lager portion are remained only for mechanical support, therefore those waveguides blocks are in general bulky and heavy in most case and not suitable for surface mounting and/or light weight applications.

Another solution is to use so called dielectric waveguides. There is a difference between dielectric waveguides and air-filled metal surface waveguides. In metal surface waveguides, the magnetic fields penetrate a short distance into the metal but the leaks become substantial if there is a gap between two layers, especially if the gap is in the horizontal direction. The reason for this is that the electromagnetic waves are tightly confined and meant to penetrate only a very short distance into the metal. For dielectric waveguides, the characteristics of the problem is different due to for example the non-propagating evanescent wave. This is also the reason why metal surface waveguides without the features as described in the appended claims requires a high level of conductivity between layers in order to reduce leakage.

A further problem in relation to manufacturing of waveguides is that the current level of CNC-milling and molding often provides bad tolerances in the production method compared to other methods such as laser cutting or etching. This makes it difficult and/or expensive to produce waveguide structures, essentially for surface mounted applications. The problem is more evident for some frequency ranges than for others, for example both CNC-milling and molding are common production methods for waveguides adapted for frequencies below 80 GHz. For waveguides, in the D-band frequency range, 110 GHz to 170 GHz, the CNC-milling and molding becomes very expensive because everything is very small in relation to how the production technology works. Thereby, it is in some cases not suitable and in some cases not even possible to achieve the desired result.

For frequency ranges that are well above 100 GHz there are technologies wherein etching on for example a silicon wafer (instead of metal block) which is used to partly solve the production problem. However, due to the properties of a waveguide this manufacturing method is not suitable for frequency range below 200 GHz. The reason for this that it is difficult to perform deep etching (for example, more than 300 um) on silicon wafer.

Thereby, some waveguides are too big to be suitable for silicon chips but too small for molded or CNC-milled versions. Further, for waveguides leakage and loss of power are common problems. The inventor have realized that waveguides with many layers generally suffers from high levels of leakage, especially if the layers are stacked on top of each other making the interface between the layers being arranged in a horizontal plane.

Even further, there are other production methods, for example using many layers of copper to make waveguides that could address the frequencies in the D-band frequency range. For such methods, for example diffusing bounding is used to enable good conductivity between layers which reduces the leakage from the waveguide. However, this manufacturing method is both expensive and requires special equipment to conduct, and even further, not suitable for mass-production of big waveguide structures.

To briefly describe the concept of the solution as described in the appended claims, there is a gap around 80-200 GHz frequency range where the CNC-milling tolerance is not enough (and as previously mentioned, CNC-milling is not suitable for mass-production), the waveguides needs to be larger than what is suitable to produce with silicon etched solutions, and wherein the bonded copper solution is to expensive and difficult to manufacture for high volume products. Further, leakage is in general a problem in all types of layered waveguides and for most application areas the weight of the waveguides has previously been a secondary factor of not to high importance. With applications, such as drones, space applications, automotive car radars, airplanes, and similar, weight reduction is a critical factor as well as compatibility with surface mounting to access high volumes.

Thus, it would be advantageous with a surface mounted waveguide that is compact, light, and that fulfils the performance requirements of the market without requiring any difficult production method. It would further be beneficial with a type of waveguide that can be used for at least all the aforementioned frequency ranges without the limitations of previous solutions. It shall be noted that the present solution as descried in the appended claims can be used also for other frequencies ranges than the D-band frequency range and thereby replacing waveguides produced with any of the other production method. It should further be noted that the structure of the present solution could be produced with CNC-milling and thereby a single type of waveguide can be used for many different application areas.

An object of the present invention is to provide a waveguide that is easy to produce.

Another object of the present invention is to provide a waveguide that is cost effective to produce.

Another object of the present invention is to provide a waveguide that is suitable for millimeter wave frequency band (30-300 GHz).

Another object of the present invention is to provide a waveguide solution that could be used for a wide range of frequencies.

Another object of the present invention is to provide a multi-layer waveguide that reduces leakage.

Another object of the present invention is to provide a multi-layer waveguide that don't require galvanic contact between the layers to reduce leakage.

Another object of the present invention is to provide a multi-layer waveguide that don't require connectivity between the layers to reduce leakage.

Another object of the present invention is to provide a waveguide with less weight than prior art solutions.

Another object of the present invention is to provide a waveguide with low form factor.

Yet another object of the present invention is to provide a production method for a multi-layer waveguide according to the aforementioned objects.

Thus, the solution relates to a multi-layer waveguide comprising at least three horizontally divided layers assembled into a multi-layer waveguide. The layers are at least a top layer, an intermediate layer, and a bottom layer. Each layer has through going holes extending through the entire layer and the holes are arranged with an offset to adjacent holes of adjoining layers creating a leak suppressing structure.

It is one advantage with the present solution that the holes are extending through the entire layer making it easier to produce. The holes of adjoining layers that are arranged with an offset in relation to each other is further advantageous due to that it creates a leak suppressing structure based on EBG, electromagnetic band gap structure.

Electromagnetic band gap (EBG) structure materials or structures creating EBG structures are designed to prevent the propagation of a designated bandwidth of frequencies and is in the present solution used to minimize the leakage in the multi-layer waveguide. This enables that a waveguide with many layers is used without the drawbacks that such a solution previously had.

It should further be noted that in for example other solutions wherein electrical and galvanic contact is needed between the layers there are much more leakage in the horizontal plane than in the vertical.

According to one embodiment the holes are not aligned but arranged in an array of unit cell pattern creating an EBG structure.

According to one embodiment the multi-layer waveguide further comprises a second top layer arranged on top of the top layer and a second bottom layer arranged underneath the bottom layer, wherein the second top and bottom layers comprises holes that extend only partly through the layer.

According to one embodiment the holes are offset from each other with a higher order symmetry.

According to one embodiment the holes are arranged with an offset so that each hole overlaps between two and four holes in the adjoining layer.

According to one embodiment the holes of an intermediate layer are arranged with an offset so that each hole overlaps between two and four holes in the adjoining layer arranged above and the adjoining layer arranged below the intermediate layer.

According to one embodiment the holes of every second layer align.

According to an embodiment of the multi-layer waveguide the layers are made from either the same material or different materials. The layers could for example be made from a metallic material, or a non-metallic material, coated with a conductive surface.

According to an embodiment the multi-layer waveguide is a air-filled rectangular waveguide.

According to an embodiment the multi-layer waveguide is a metal waveguide.

According to an embodiment the multi-layer waveguide is a metal surface waveguide.

According to an embodiment the multi-layer waveguide is a metallic rectangular waveguide.

According to an embodiment of the multi-layer waveguide the layers of the multi-layer waveguide is held together with any one of a conductive glue, an isolating glue, and two screws.

It is one advantage with the present solution that any form of bonding or attachment means can be used to hold the layers together. The reason for this is that no electric conductivity is required between the layers in order to suppress leakage. However, it shall be noted that conductivity won't affect the performance in a negative way. I.e. the multi-layer waveguide according to the solution as described herein works well regardless of the conductive properties between the layers.

According to an embodiment the multi-layer waveguide is held together with less than three attachment means, preferably screws or rivets.

According to an embodiment there is a gap dividing the layers.

It is one advantage with the multi-layer waveguide as described herein that a small gap between the layers won't affect the waveguide properties. This is contrary to most other waveguides wherein a gap significantly would increase the leakage.

According to an embodiment each of the layers has a different pattern of holes and/or elongated aperture.

According to an embodiment of the multi-layer waveguide the holes are of any suitable shape, preferably circular, triangular, square, pentagonal, rectangular, rectangular, square, hexagonal, or any other shape. It is understood that the shape of the holes in the layers won't affect the functionality as long as the EBG property is achieved.

According to an embodiment of the multi-layer waveguide, the holes in the layers are arranged to achieve an electromagnetic band gap structure in the material.

According to an embodiment the distance between the holes in each layer is smaller than the wavelength that the multi-layer waveguide is designed for.

According to an embodiment the diameter of the hole is between 0.4 * lambda - 0.6 * lambda and the period of the holes is between 0.8*lambda-1.2* lambda, wherein lambda is the wavelength in free space.

According to an embodiment the diameter of the hole is approximately 0.4*lambda and the period of the holes is approximately 0.8 lambda, wherein lambda is the wavelength in free space.

According to an embodiment the diameter of the hole is approximately 0.5 * lambda and the period of the holes is approximately 1.2* lambda, wherein lambda is the wavelength in free space.

According to an embodiment the holes reoccur in a repeating pattern.

According to an embodiment the multi-layer waveguide comprises a waveguide channel. The waveguide channel is an elongated aperture in at least one intermediate layer.

It is one advantage that the waveguide channel of the multi-layer waveguide can be produced as a through going elongated aperture in one or more intermediate layer. From a production perspective, it is much easier to produce an aperture that extends through the entire thickness of a layer than to produce a slot that only extends part of the thickness. Through arranging multiple layers the waveguide channel is created as an enclosed space made of the one or more elongated apertures. The top and bottom layers is in one embodiment together with the sides of the elongated apertures the enclosing members creating a waveguide channel.

According to an embodiment the multi-layer waveguide comprises a waveguide channel inlet aligning with a start of the waveguide channel and a waveguide channel outlet aligning with an end of the waveguide channel. Either the waveguide channel inlet is arranged in the top layer or the waveguide channel inlet is arranged in the bottom layer. For the outlet, either the waveguide channel outlet is arranged in the top layer or the waveguide channel outlet is arranged in the bottom layer.

According to an embodiment the multi-layer waveguide comprises a waveguide channel inlet aligning with a start of the waveguide channel and a waveguide channel outlet aligning with an end of the waveguide channel, wherein the waveguide channel inlet is arranged according to any one of:
- in the top layer,
- in the bottom layer,
and the waveguide channel outlet is arranged according to any one of:
- in the top layer,
- in the bottom layer.

According to an embodiment of the multi-layer waveguide comprises a top layer that has a waveguide channel inlet aligning with a start of the waveguide channel in the intermediate layer and a waveguide channel outlet aligning with the end of the waveguide channel in the intermediate layer.

According to an embodiment of the multi-layer waveguide, the waveguide comprises at least one row of holes are arranged around the waveguide channel.

According to an embodiment of the multi-layer waveguide, the waveguide comprises at least two rows of holes are arranged around the waveguide channel.

According to an embodiment of the multi-layer waveguide the layers of the multi-layer waveguides have the same size.

According to an embodiment the multi-layer waveguide has at least a first, a second, and a third intermediate layer and each intermediate layer comprises an elongated aperture arranged concentric for each intermediate layer.

According to an embodiment of the multi-layer waveguide the elongated aperture in the first intermediate layer is longer than the elongated aperture in the second intermediate layer and the elongated aperture in the second intermediate layers is longer than the elongated aperture in the third intermediate layer.

It is one advantage that through changing the length of the elongated apertures in each intermediate layer it is possible to achieve a step structure at each end of the waveguide channel in the assembled multi-layer waveguide. This enables the inlet and outlet to be directed either upwards or downwards enabling surface mounting of the waveguide.

According to an embodiment of the multi-layer waveguide:
- the first, second, and third intermediate layers each comprises an elongated aperture, and
- the second intermediate layer further comprises a central member arranged within the elongated aperture.

It is one advantage with the multi-layer structure of the waveguide that a coaxial waveguide can be produced in an effective way via arranging a central member in the elongated aperture of an intermediate layer. It is further an advantage with coaxial waveguides that it creates a compact waveguide structure. The center member in one embodiment on fills part of the width of the elongated aperture in the intermediate layer.

It is yet another advantage that a rectangular coaxial transmission line, such as the coaxial multi-layer waveguide as described herein, creates a waveguide structure with more than one octave bandwidth.

**It** is another advantage that the coaxial waveguide as described herein is suitable for use as an antenna or a filter.

**It** is another advantage with the present solution that a waveguide transmission line which can be used to design any waveguide device is achieved, for example slotted array antennas, filters, rectangular waveguides, and coaxial waveguides.

According to an embodiment of the multi-layer waveguide the waveguide channel comprises multiple side flanges extending in a direction perpendicular to the extension direction of said waveguide channel.

**It** is one advantage with the side flanges that they reduce leakage through minimizing the waves ability to couple with the edge and propagate. Waves coupling to the edge of a waveguide loses energy which is at least in part prevented with the flanges as described herein.

According to an aspect a multi-layer waveguide arrangement comprises a multi-layer waveguide as described in any of the embodiments above and wherein an active component is arranged in the waveguide channel of the multi-layer waveguide.

It is one advantage that an integrated circuit, such as a MMIC or any other form of active component, could be arranged within the waveguide channel.

According to an aspect a layer for a multi-layer waveguide, is a layer adapted for a multi-layer waveguide and/or a multi-waveguide arrangement as described above.

According to an aspect for producing a multi-layer waveguide, wherein the production comprises the steps of etching or laser cutting:
- a top layer comprising at least one row of through going holes surrounding an elongated area in the center area of the layer,
- at least one intermediate layer comprising at least one row of through going holes surrounding an elongated area in the center area of the layer and wherein an elongated aperture is etched or laser cut into the elongated area, and
- a bottom layer comprising at least one row of through going holes surrounding an elongated area in the center area of the layer.

According to one embodiment the rows of through going holes are arranged with an offset between adjoining layers.

According to an aspect for producing a multi-layer waveguide, wherein the production comprises the steps of etching or laser cutting:
- a top layer comprising at least two rows of through going holes surrounding an elongated area in the center area of the layer,
- at least one intermediate layer comprising at least two rows of through going holes surrounding an elongated area in the center area of the layer and wherein an elongated aperture is etched or laser cut into the elongated area, and
- a bottom layer comprising at least two rows of through going holes surrounding an elongated area in the center area of the layer.

According to an embodiment the production further comprises the step of etching or laser cutting:
- a waveguide channel inlet and a waveguide channel outlet into the top layer.

According to an embodiment the production further comprises the step of etching or laser cutting:
- a waveguide channel inlet into any one of the top layer or the bottom layer, and
- a waveguide channel outlet into any one of the top layer or the bottom layer.

According to an embodiment the layers are held together with any one of a conductive glue, an isolating glue, or screws.

The solution as presented herein has multiple advantage, it is for example cost efficient to produce, through going holes are easier to produce than slots, leakage is reduced without any expensive bonding process, etc.

### Brief description of drawings

The invention is now described, by way of example, with reference to the accompanying drawings, in which:
Fig. 1 illustrates one embodiment of multiple layers for a multi-layer waveguide.
Fig. 2 illustrates one embodiment of an assembled multi-layer waveguide comprising the layers as illustrated in figure 1.
Fig. 3 illustrates two examples of layers for a multi-layer waveguide.
Fig. 4 illustrates one embodiment of a hole pattern for a top layer in a multi-layer waveguide.
Fig. 5 illustrates a vertical cross-section of one embodiment of a multi-layer waveguide.
Fig. 6 illustrates one embodiment of multiple layers for a multi-layer waveguide.
Fig. 7 illustrates a vertical cross-section of one embodiment of a coaxial multi-layer waveguide.
Fig. 8 illustrates a vertical cross-section of one embodiment of a coaxial multi-layer waveguide.
Fig. 9a-c illustrates different embodiments of hole patterns for layers in a multi-layer waveguide.
Fig. 10a illustrates one embodiment of two layers for a multi-layer waveguide shown side-by-side.
Fig. 10b illustrates the two layers as shown in figure 10a instead illustrated on top of each other showing one embodiment of the offset between holes in adjacent layers for a multi-layer waveguide.
Fig. 11 illustrates one embodiment of multiple layers for a multi-layer waveguide with a second top and bottom layer.
Fig. 12 illustrates one embodiment of an assembled multi-layer waveguide comprising the layers as illustrated in figure 11.
Fig. 13 illustrates another view of the embodiment as illustrated in figures 11 and 12.
Fig. 14 illustrates one example of a waveguide device wherein the waveguide channel is arranged to be used as a filter.

### Description of embodiments

In the following, a detailed description of the different embodiments of the invention is disclosed under reference to the accompanying drawings. All examples herein should be seen as part of the general description and are therefore possible to combine in any way of general terms. Individual features of the various embodiments and aspects may be combined or exchanged unless such combination or exchange is clearly contradictory to the overall function of the multi-layer waveguide, arrangement, or production method thereof.

Briefly described the solution relates to a multi-layer waveguide without any requirement for electrical and galvanic contact between the layers. The multi-layer waveguide has a leak suppressing structure for reducing leakage between the layers of said waveguide. The leak suppressing structure comprise multiple holes that are arranged in at least one row surrounding the waveguide channel and the holes are arranged with an offset between the layers creating an EBG-structure (electromagnetic band gap).

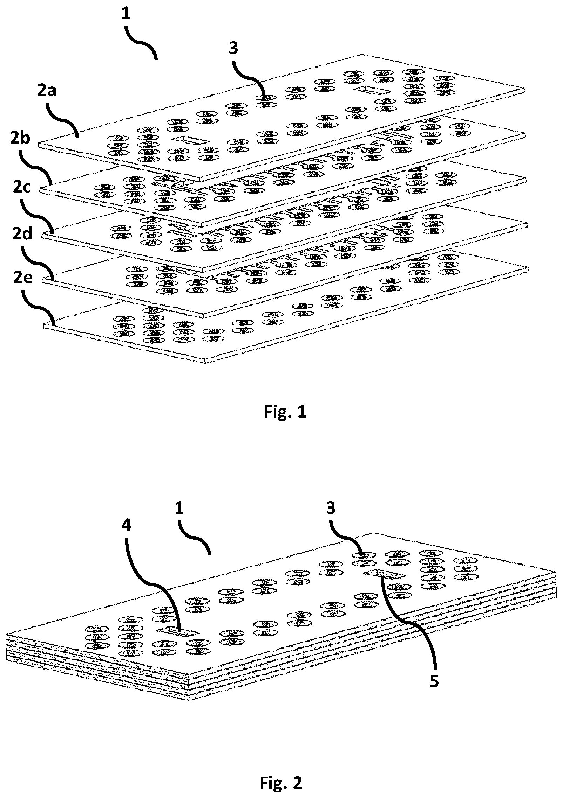

Figure 1 illustrates one embodiment of layers 2a, 2b, 2c, 2d, 2e for a multi-layer waveguide 1. The layers as illustrated in figure 1 each comprises holes 3 that are arranged with an offset between the different layers, or at least between adjoining layers. Figure 1 further illustrates the orientation of the layers as described herein wherein the top layer 2a is above the intermediate layers 2b, 2c, 2d and the intermediate layers 2b, 2c, 2d are above the bottom layer 2e. However, it should be noted that any number of layers can be used within the multi-layer waveguide and the multi-layer waveguide can be arranged in any direction during use. The orientation and how that relates to the order of the layers is merely for explanatory reasons. However, in some embodiments the multi-layer waveguide might be arranged as illustrated and described herein.

Figure 2 illustrates a multi-layer waveguide 1 comprising the layers of figure 1. Figure 2 further illustrates how the waveguide 1 comprises a waveguide channel inlet 4 and a waveguide channel inlet 5 being apertures, holes, or openings in this embodiment in the top layer 2a of the multi-layer waveguide 1.

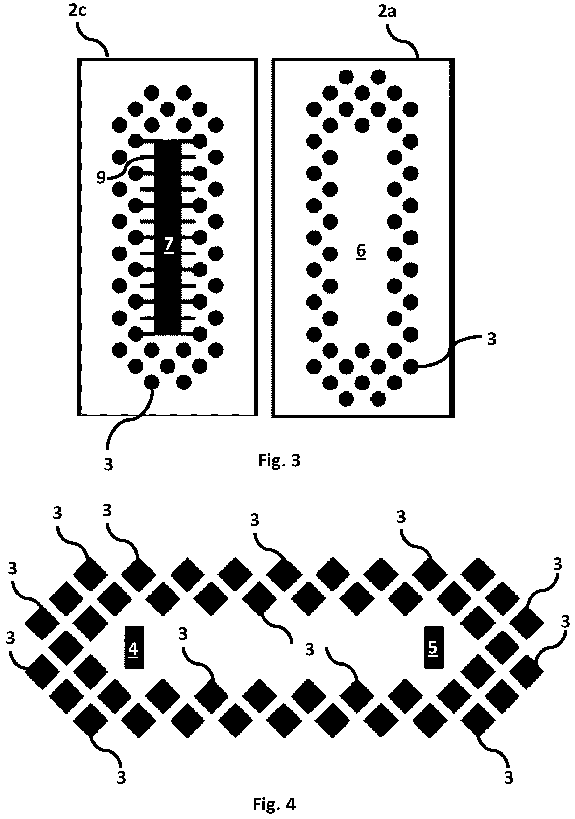

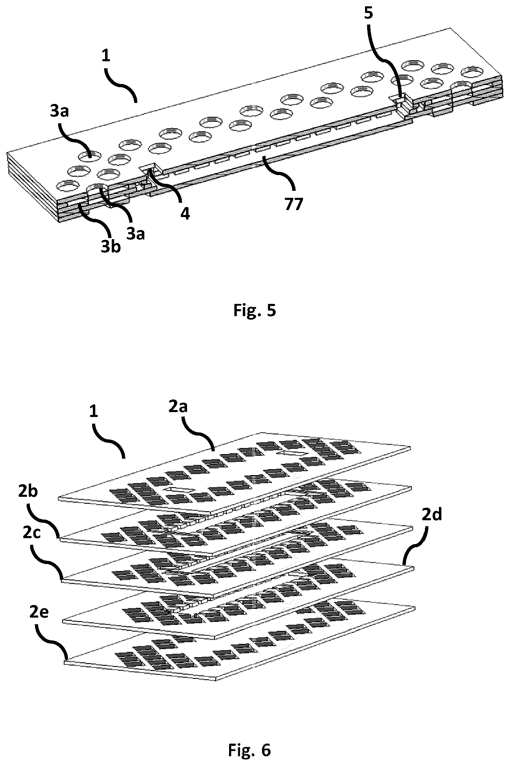

Figure 3 illustrates one embodiment of a top layer 2a and an intermediate layer 2c showing an example of how the pattern of holes, inlet, outlet, and apertures for different layers might look. Figure 3 further illustrates an elongated aperture 7 that in an assembled multi-layer waveguide 1 either on its own or together with elongated apertures 7 of adjoining layers forms the waveguide channel 77, see for example figure 5.

In figure 3 an elongated area 6 of, in this embodiment, the top layer 2a is shown. The elongated area 6 is a solid part of the layer meanwhile for example the holes 3, elongated apertures 7, inlets 4, 5 etc. are material that is removed to create through going openings in the layer.

Figure 4 illustrates one embodiment of the pattern of a layer. This layer might in different embodiments be either a top layer 2a, a bottom layer 2e, or an intermediate layer. In the embodiment wherein figure 4 illustrates an intermediate layer a multi-layer waveguide comprising such a layer would also comprise a top 2a or bottom 2b layer having the waveguide inlet 4 and waveguide inlet 5 arranged at the same place but with holes 3 arranged with an offset.

Figure 5 illustrates a cross section of one embodiment of a multi-layer waveguide 1 wherein the holes 3 are illustrated as holes 3 in different layers 3a, 3b. The holes 3a in the top layer 2a are arranged with an offset to the holes 2b in the intermediate layer 2b as can be seen in figure 5. The cross section is here within the waveguide channel 77 which is clearly visible in figure 5. Figure 5 further illustrates an embodiment of the multi-layer waveguide 1 wherein the waveguide channel 77 comprises a step structure arranged at each end of the waveguide channel 77 to better direct an electromagnetic wave towards the waveguide channel outlet 5 respectively into the waveguide channel 77 from the waveguide channel inlet 4.

Figure 6 illustrates one embodiment of layers 2a, 2b, 2c, 2d, 2e for a multi-layer waveguide 1. The layers as illustrated in figure 1 each comprises holes 3 that are arranged with an offset between the different layers, or at least between adjoining layers. Figure 1 further illustrates the orientation of the layers as described herein wherein the top layer 2a is above the intermediate layers 2b, 2c, 2d and the intermediate layers 2b, 2c, 2d are above the bottom layer 2e. However, it should be noted that any number of layers can be used within the multi-layer waveguide and the multi-layer waveguide can be arranged in any direction during use. The orientation and how that relates to the order of the layers is merely for explanatory reasons. However, in some embodiments the multi-layer waveguide might be arranged as illustrated and described herein.

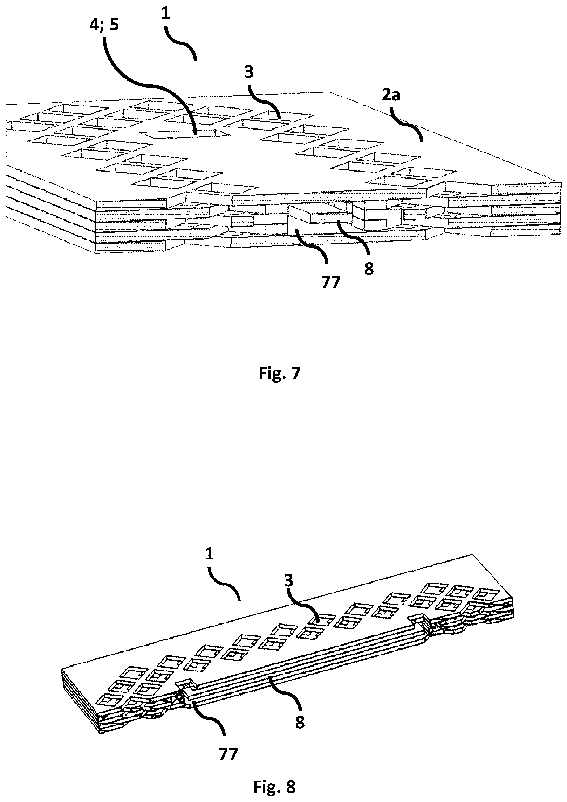

Figure 7 illustrate a cross section of one embodiment of the multi-layer waveguide 1 wherein a central member 8 is arranged within the waveguide channel 77 creating a coaxial waveguide. It is understood that the central member 8 might have any form or shape. The central member 8 could further be arranged in multiple layers if other structures of the coaxial waveguide is desired.

Figure 8 illustrates another cross section of one embodiment of a coaxial waveguide wherein a central member 8 is arranged in the center part of the waveguide channel 77.

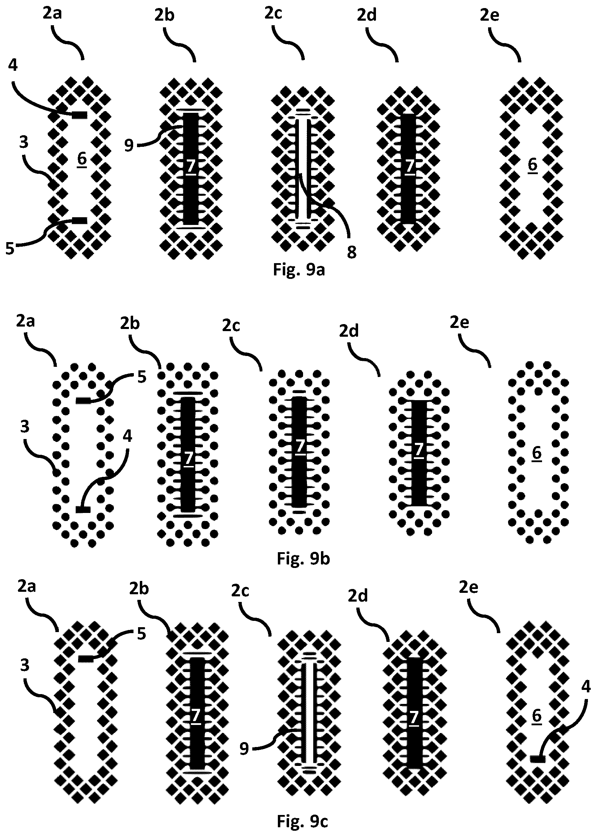

Figure 9a-c illustrates different embodiments of patterns for layers in a multi-layer waveguide 1 wherein the openings 3, waveguide channel inlet 4 and outlet 5, and elongated apertures 7 are illustrated. It is understood that the inlet 4 and outlet 5 might switch place without affecting the overall function of the waveguide, i.e. that the direction for guiding waves in the waveguide can be switched.

Figure 9a illustrates a multi-layer coaxial waveguide with a rectangular cross section. The top layer 2a comprises multiple holes 3 arranged in two rows surrounding an elongated area 6. In the elongated area 6 is a waveguide channel inlet 4 and a waveguide channel outlet 5 arranged, both being through going apertures extending through the top layer 2a.

The first intermediate layer 2b shows a number of flanges 9 arranged around an elongated aperture 7 that is part of the waveguide channel 77. The elongated aperture 7 extends between and connects to the inlet 4 and outlet 5 as illustrated. The second intermediate layer 2c comprises a central member 8 that is a solid member that when the waveguide 1 is assembled will create the part making the waveguide channel 77 coaxial. The third intermediate layer 2d illustrates an elongated aperture 7 with flanges.

Further relating to the flanges 9, in one embodiment the flanges are reversed, i.e. extending into the waveguide channel 77.

It is one advantage with the side flanges that they reduce leakage through minimizing the waves ability to couple with the edge and propagate. This is due to the discontinuity in the edge. Waves coupling to the edge of a waveguide loses energy which is at least in part prevented with the flanges as described herein.

According to one embodiment the flanges are reversed, i.e. extending into the waveguide channel 77.

Figure 9a further illustrates a bottom layer 2e with two rows of holes 3 and an elongated area 6

Figure 9b illustrates another embodiment of layers in a multi-layer waveguide 1 wherein the holes 3 are round instead of square as in figure 9a. Further figure 9b illustrates layers for a multi-layer waveguide 1 that isn't coaxial.

Figure 9c illustrates another embodiment of a coaxial multi-layer waveguide wherein the waveguide channel inlet 4 is arranged in the bottom layer 2e and the waveguide channel outlet 5 is arranged in the top layer 2a.

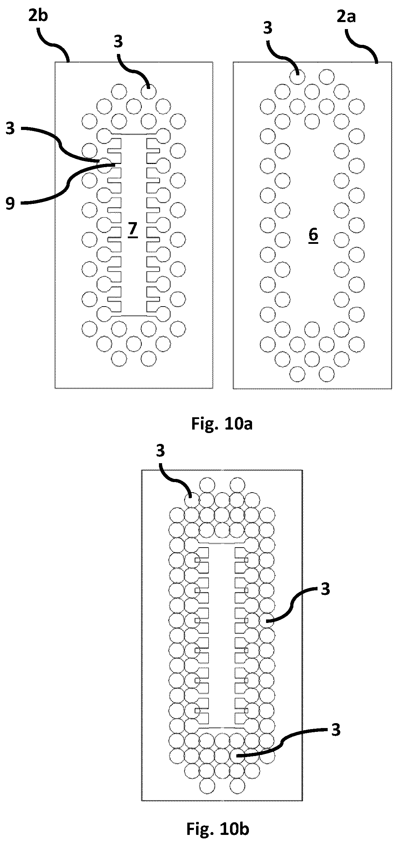

Figure 10a illustrates a top layer 2a and an intermediate layer 2b side by side showing the holes 3.

Figure 10b illustrates the top layer 2a and the intermediate layer 2b that are illustrated in figure 10a but with the layers stacked on top of each other. From this view, it is clear how the offset of the holes 3 in one embodiment could look like. However, it should be noted that the solution is not limited to any specific design and any pattern of holes 3 that creates an EBG structure is within the scope of the solution.

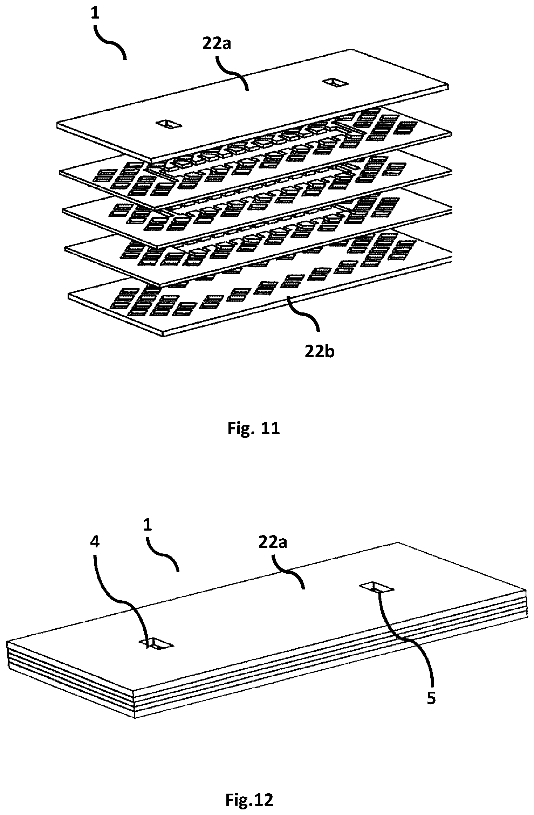

Figure 11 illustrates another embodiment of a multi-layer waveguide 1. In the embodiment as illustrated in figure 11 the waveguide comprises one additional top layer 22a and one additional bottom 22b layer. The additional layers have holes 33 that don't extend the entire length through the layer.

Figure 12 illustrates a multi-layer waveguide 1 comprising the layers of figure 11. Figure 12 further illustrates how the waveguide 1 comprises a waveguide channel inlet 4 and a waveguide channel inlet 5 being apertures, holes, or openings in this embodiment in the additional top layer of the multi-layer waveguide 1.

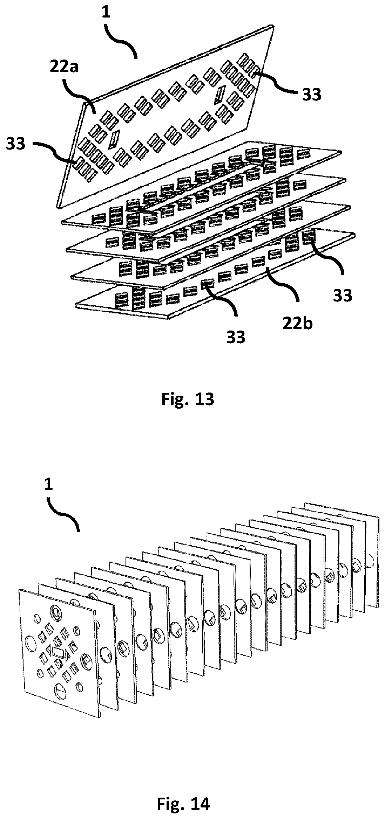

Figure 13 illustrates the layers of the embodiment as illustrated in figure 11 and 12.

Figure 14 illustrates another embodiment of a multi-layer waveguide as claimed in the independent claims. The multi-layer waveguide has another form of waveguide channel than some of the other embodiments, wherein for the embodiment as illustrated in figure 14 the waveguide channel extends perpendicular through the extension direction of the layers.

## Claims

1. A multi-layer waveguide device comprising at least three stacked layers assembled into a multi-layer waveguide (1), wherein the layers are at least a top layer (2a), an intermediate layer (2c), and a bottom layer (2e), each layer has through going holes (3) extending through the entire layer and **characterised in that** the holes (3) are arranged with an offset to adjacent holes (3) of adjoining layers configured to create a leak suppressing electromagnetic band gap structure.

2. The multi-layer waveguide device according to claim 1, wherein the multi-layer waveguide (1) comprises a waveguide channel (77), said waveguide channel (77) being an aperture extending through all layers.

3. The multi-layer waveguide device according to claim 1, wherein the multi-layer waveguide (1) comprises a waveguide channel (77), said waveguide channel (77) is an elongated aperture (7) in at least one intermediate layer (2b).

4. The multi-layer waveguide device according to claim 3, wherein the multi-layer waveguide (1) comprises a waveguide channel inlet (4) aligning with a start of the waveguide channel (77) and a waveguide channel outlet (5) aligning with an end of the waveguide channel (77), wherein the waveguide channel inlet (4) is arranged according to any one of:
- in the top layer (2a),
- in the bottom layer (2e),
and the waveguide channel outlet (5) is arranged according to any one of:
- in the top layer (2a),
- in the bottom layer (2e).

5. The multi-layer waveguide device according to any one of claims 2-4, wherein at least one row of holes (3) is arranged around the waveguide channel (77).

6. The multi-layer waveguide device according to claim 1, or 3-5, wherein the multi-layer waveguide (1) has at least a first (2b), a second (2c), and a third (2d) intermediate layer, and wherein each intermediate layer (2b, 2c, 2d) comprises an elongated aperture (7) arranged concentric for each intermediate layer (2b, 2c, 2d).

7. The multi-layer waveguide device according to claim 6, wherein the elongated aperture (7) in the first intermediate layer (2b) is longer than the elongated aperture (7) in the second intermediate layer (2c) and the elongated aperture (7) in the second intermediate layers (2c) is longer than the elongated aperture (7) in the third intermediate layer (2d).

8. The multi-layer waveguide device according to any one of claim 6 or 7, wherein
- the first (2b), second (2c), and third (2d) intermediate layers each comprises an elongated aperture (7), and
- the second intermediate layer (2c) further comprises a central member (8) arranged within the elongated aperture (7), thereby forming a coaxial waveguide.

9. The multi-layer waveguide device according to any one of claims 2-8, wherein the waveguide channel (77) comprises multiple side flanges (9) extending in a direction perpendicular to the extension direction of said waveguide channel (77).

10. The multi-layer waveguide device according to any one of claims 1-9, wherein the multi-layer waveguide (1) further comprises at least one of a second top layer (22a) arranged on top of the top layer (2a) and a second bottom layer (22b) arranged underneath the bottom layer (2e), wherein said at least one of the second top (22a) and bottom (22b) layers comprises holes (33) that extend only partly through the layer.

11. The multi-layer waveguide device according to any one of claims 1-10, wherein the multi-layer waveguide is arranged as any one of a slotted array antenna, a filter, a rectangular waveguide, and a coaxial waveguide.

12. A multi-layer waveguide arrangement comprising a multi-layer waveguide (1) according to any one of claims 2-11, wherein an active component is arranged in the waveguide channel (77) of the multi-layer waveguide (1).

13. A method for producing a multi-layer waveguide device according to any one of claims 1-11, wherein the method comprises the steps of etching or laser cutting:
- a top layer (2a) comprising at least one row of through going holes (3) surrounding an elongated area (6) in the center area of the layer,
- at least one intermediate layer (2b, 2c, 2d) comprising at least one row of through going holes (3) surrounding an elongated area (6) in the center area of the layer and wherein an elongated aperture (7) is etched or laser cut into the elongated area (6), and
- a bottom layer (2e) comprising at least one row of through going holes (3) surrounding an elongated area (6) in the center area (6) of the layer.

14. The method according to claim 13, wherein the layers are held together with any one of a conductive glue, an isolating glue, or screws.

## Patentansprüche

1. Mehrschichtige Hohlleitervorrichtung, aufweisend mindestens drei gestapelte Schichten, die in einen mehrschichtigen Hohlleiter (1) montiert sind, wobei die Schichten mindestens eine obere Schicht (2a), eine Zwischenschicht (2c) und eine untere Schicht (2e) aufweisen, wobei jede Schicht Durchgangslöcher (3) aufweist, die sich durch die gesamte Schicht erstrecken und **dadurch gekennzeichnet sind, dass** die Löcher (3) mit einem Versatz zu angrenzenden Löchern (3) benachbarter Schichten angeordnet sind, die eingerichtet sind, um eine leckunterdrückende elektromagnetische Bandlückenstruktur zu erzeugen.

2. Mehrschichtige Hohlleitervorrichtung nach Anspruch 1, wobei der mehrschichtige Hohlleiter (1) einen Hohlleiterkanal (77) aufweist und der Hohlleiterkanal (77) eine Öffnung darstellt, die sich durch alle Schichten erstreckt.

3. Mehrschichtige Hohlleitervorrichtung nach Anspruch 1, wobei der mehrschichtige Hohlleiter (1) einen Hohlleiterkanal (77) aufweist und der Hohlleiterkanal (77) eine längliche Öffnung (7) in mindestens einer Zwischenschicht (2b) darstellt.

4. Mehrschichtige Hohlleitervorrichtung nach Anspruch 3, wobei der mehrschichtige Hohlleiter (1) einen Hohlleiterkanaleinlass (4) aufweist, der an einem Start des Hohlleiterkanals (77) ausgerichtet ist, und einen Hohlleiterkanalauslass (5), der an einem Ende des Hohlleiterkanals (77) ausgerichtet ist, wobei der Hohlleiterkanaleinlass (4) nach einem der folgenden angeordnet ist:
- in der oberen Schicht (2a),
- in der unteren Schicht (2e), und der Hohlleiterkanalauslass (5) nach einem der folgenden angeordnet ist:
- in der oberen Schicht (2a),
- in der unteren Schicht (2e).

5. Mehrschichtige Hohleitervorrichtung nach einem der Ansprüche 2-4, wobei mindestens eine Lochreihe (3) um den Hohlleiterkanal (77) herum angeordnet ist.

6. Mehrschichtige Hohlleitervorrichtung nach Anspruch 1 oder 3 bis 5, wobei der mehrschichtige Hohlleiter (1) mindestens eine erste (2b), eine zweite (2c) und eine dritte (2d) Zwischenschicht aufweist, und wobei jede Zwischenschicht (2b, 2c, 2d) eine längliche Öffnung (7) aufweist, die für jede Zwischenschicht (2b, 2c, 2d) konzentrisch angeordnet ist.

7. Mehrschichtige Hohlleitervorrichtung nach Anspruch 6, wobei die längliche Öffnung (7) in der ersten Zwischenschicht (2b) länger als die längliche Öffnung (7) in der zweiten Zwischenschicht (2c) ist und die längliche Öffnung (7) in der zweiten Zwischenschicht (2c) länger ist als die längliche Öffnung (7) in der dritten Zwischenschicht (2d).

8. Mehrschichtige Hohlleitervorrichtung nach einem der Ansprüche 6 oder 7, wobei
- die erste (2b), zweite (2c) und dritte (2d) Zwischenschicht jeweils eine längliche Öffnung (7) aufweist, und
- die zweite Zwischenschicht (2c) ferner ein zentrales Element (8) aufweist, das in der länglichen Öffnung (7) angeordnet ist, wodurch ein koaxialer Hohlleiter gebildet wird.

9. Mehrschichtige Hohlleitervorrichtung nach einem der Ansprüche 2 bis 8, wobei der Hohlleiterkanal (77) mehrere Seitenflansche (9) aufweist, die sich in eine Richtung erstrecken, die rechtwinklig zu der Erstreckungsrichtung des Hohlleiterkanals (77) ist.

10. Mehrschichtige Hohlleitervorrichtung nach einem der Ansprüche 1 bis 9, wobei der mehrschichtige Hohlleiter (1) ferner mindestens eine zweite obere Schicht (22a) aufweist, die auf der oberen Schicht (2a) angeordnet ist, und eine zweite untere Schicht (22b), die unter der oberen Schicht (2e) angeordnet ist, wobei die mindestens eine aus den zweiten oberen (22a) und unteren (22b) Schichten Löcher (33) aufweist, die sich nur teilweise durch die Schicht erstrecken.

11. Mehrschichtige Hohleitervorrichtung nach einem der Ansprüche 1 bis 10, wobei der mehrschichtige Hohlleiter als eines aus einer schlitzförmigen Array-Antenne, einem Filter, einem rechteckigen Hohlleiter und einem koaxialen Hohlleiter angeordnet ist.

12. Mehrschichtige Hohlleiteranordnung, aufweisend einen mehrschichtigen Hohlleiter (1) nach einem der Ansprüche 2 bis 11, wobei eine aktive Komponente in dem Hohlleiterkanal (77) des mehrschichtigen Hohlleiters (1) angeordnet ist.

13. Verfahren zum Herstellen einer mehrschichtigen Hohleitervorrichtung nach einem der Ansprüche 1 bis 11, wobei das Verfahren die Schritte des Ätzens oder Laserschneidens der folgenden Elemente aufweist:
- eine obere Schicht (2a), umfassend mindestens eine Reihe von Durchgangslöchern (3), die einen länglichen Bereich (6) in dem Mittelbereich der Schicht umschließen,
- mindestens eine Zwischenschicht (2b, 2c, 2d), umfassend mindestens eine Reihe von Durchgangslöchern (3), die einen länglichen Bereich (6) in dem mittleren Bereich der Schicht umschließen und wobei eine längliche Öffnung (7) in den länglichen Bereich (6) geätzt oder lasergeschnitten ist, und
- eine untere Schicht (2e), aufweisend mindestens eine Reihe von Durchgangslöchern (3), die einen länglichen Bereich (6) in dem Mittelbereich (6) der Schicht umschließen.

14. Verfahren nach Anspruch 13, wobei die Schichten mit einem aus einem leitfähigen Klebstoff, einem isolierenden Klebstoff oder Schrauben zusammengehalten werden.

## Revendications

1. Dispositif de guide d'ondes multicouches comprenant au moins trois couches empilées assemblées en un Dispositif de guide d'ondes multicouches (1), dans lequel les couches sont constituées d'au moins une couche supérieure (2a), une couche intermédiaire (2c) et une couche inférieure (2e), chaque couche présente des trous traversants (3) traversant la totalité de la couche et **caractérisé en ce que** les trous (3) sont décalés par rapport aux trous adjacents (3) des couches adjacentes configurées afin de créer une structure de bande interdite électromagnétique supprimant les fuites.

2. Dispositif de guide d'ondes multicouches selon la revendication 1, dans lequel le Dispositif de guide d'ondes multicouches (1) comprend un canal de guide d'ondes (77), ledit canal de guide d'ondes (77) étant une ouverture traversant toutes les couches.

3. Dispositif de guide d'ondes multicouches selon la revendication 1, dans lequel le Dispositif de guide d'ondes multicouches (1) comprend un canal de guide d'ondes (77), ledit canal de guide d'ondes (77) est une ouverture allongée (7) ménagée dans au moins une couche intermédiaire (2b).

4. Dispositif de guide d'ondes multicouches selon la revendication 3, dans lequel le Dispositif de guide d'ondes multicouches (1) comprend une entrée de canal de guide d'ondes (4) alignée avec un début du canal de guide d'ondes (77) et une sortie de canal de guide d'ondes (5) alignée avec une extrémité de canal de guide d'ondes (77), dans lequel l'entrée de canal de guide d'ondes (4) est disposée selon une quelconque des configurations suivantes :
- dans la couche supérieure (2a),
- dans la couche inférieure (2e) et la sortie de canal de guide d'ondes (5) est disposée selon une quelconque des configurations suivantes :
- dans la couche supérieure (2a),
- dans la couche inférieure (2e).

5. Dispositif de guide d'ondes multicouches selon une quelconque des revendications 2 à 4, dans lequel au moins une rangée de trous (3) est disposée autour du canal de guide d'ondes (77).

6. Dispositif de guide d'ondes multicouches selon la revendication 1 ou 3 à 5, dans lequel le Dispositif de guide d'ondes multicouches (1) comporte au moins une première (2b), une deuxième (2c) et une troisième (2d) couches intermédiaires et dans lequel chaque couche intermédiaire (2b, 2c, 2d) comprend une ouverture allongée (7) disposée concentriquement à chaque couche intermédiaire (2b, 2c, 2d).

7. Dispositif de guide d'ondes multicouches selon la revendication 6, dans lequel l'ouverture allongée (7) dans la première couche intermédiaire (2b) est plus longue que l'ouverture allongée (7) dans la deuxième couche intermédiaire (2c), et l'ouverture allongée (7) dans la deuxième couche intermédiaire (2c) est plus longue que l'ouverture allongée (7) dans la troisième couche intermédiaire (2d).

8. Dispositif de guide d'ondes multicouches selon une quelconque des revendications 6 ou 7, dans lequel
- les première (2b), deuxième (2c) et troisième (2d) couches intermédiaires comprennent chacune une ouverture allongée (7) et
- la deuxième couche intermédiaire (2c) comprend en outre un élément central (8) disposé à l'intérieur de l'ouverture allongée (7), formant ainsi un guide d'ondes coaxial.

9. Dispositif de guide d'ondes multicouches selon une quelconque des revendications 2 à 8, dans lequel le canal de guide d'ondes (77) comprend plusieurs rebords latéraux (9) s'étendant perpendiculairement à la direction d'extension dudit canal (77).

10. Dispositif de guide d'ondes multicouches selon une quelconque des revendications 1 à 9, dans lequel le dispositif de guide d'ondes multicouches (1) comprend en outre au moins une deuxième couche supérieure (22a) disposée au-dessus de la couche supérieure (2a) et une deuxième couche inférieure (22b) disposée au-dessous de la couche inférieure (2e), dans lequel ladite au moins une des deuxièmes couches supérieure (22a) et inférieure (22b) comprend des trous (33) qui ne la traversent que partiellement.

11. Dispositif de guide d'ondes multicouches selon une quelconque des revendications 1 à 10, dans lequel le dispositif de guide d'ondes multicouches est agencé comme un quelconque d'une antenne réseau à fentes, un filtre, un guide d'ondes rectangulaire et un guide d'ondes coaxial.

12. Agencement de guide d'ondes multicouches comprenant un guide d'ondes multicouches (1) selon une quelconque des revendications 2 à 11, dans lequel un composant actif est disposé dans le canal de guide d'ondes (77) du guide d'ondes multicouches (1).

13. Procédé de fabrication d'un dispositif de guide d'ondes multicouches selon une quelconque des revendications 1 à 11, dans lequel le procédé comprend les étapes de gravure ou de découpe laser :
- une couche supérieure (2a) comprenant au moins une rangée de trous traversants (3) entourant une zone allongée (6) au centre de la couche ;
- au moins une couche intermédiaire (2b, 2c, 2d) comprenant au moins une rangée de trous traversants (3) entourant une zone allongée (6) au centre de la couche et dans lequel une ouverture allongée (7) est gravée ou découpée au laser dans la zone allongée (6) ; et
- une couche inférieure (2e) comprenant au moins une rangée de trous traversants (3) entourant une zone allongée (6) au centre (6) de la couche.

14. Procédé selon la revendication 13, dans lequel les couches sont maintenues ensemble par une quelconque d'une colle conductrice, une colle isolante ou des vis.
